(19) Europäisches Patentamt / European Patent Office / Office européen des brevets

(11) **EP 2 416 633 A1**

(12) **EUROPÄISCHE PATENTANMELDUNG**

(43) Veröffentlichungstag:
**08.02.2012 Patentblatt 2012/06**

(51) Int Cl.:
**H05K 3/30** *(2006.01)*    **H01L 21/56** *(2006.01)*
**H05K 13/04** *(2006.01)*    **C09J 163/00** *(2006.01)*

(21) Anmeldenummer: **10450127.5**

(22) Anmeldetag: **04.08.2010**

(84) Benannte Vertragsstaaten:
**AL AT BE BG CH CY CZ DE DK EE ES FI FR GB
GR HR HU IE IS IT LI LT LU LV MC MK MT NL NO
PL PT RO SE SI SK SM TR**
Benannte Erstreckungsstaaten:
**BA ME RS**

(71) Anmelder: **AT & S Austria Technologie &
Systemtechnik
Aktiengesellschaft
8700 Leoben-Hinterberg (AT)**

(72) Erfinder:
• **Schrittwieser, Wolfgang
8605 Kapfenberg (AT)**
• **Lenhardt, Patrick
8724 Spielberg (AT)**
• **Grasser, Patrick
8724 Spielberg (AT)**

(74) Vertreter: **Miksovsky, Alexander
Patentanwalt Miksovsky KG
Garnisongasse 4
Postfach (POB) 32
1096 Wien (AT)**

(54) **Verfahren ur Festlegung und/oder Einbettung eines elektronischen Bauteils sowie Kleber zur Verwendung in einem derartigen Verfahren**

(57)    Bei einem Verfahren zur Festlegung eines elektronischen Bauteils (3) an einer Leiterplatte (1) und/oder zur Einbettung eines elektronischen Bauteils (3) in eine Leiterplatte (1), wobei der festzulegende und/oder einzubettende elektronische Bauteil (3) über eine Klebeverbindung (2) an einer Lage bzw. Schicht einer insbesondere mehrlagigen Leiterplatte (1) festgelegt wird und nach einem Festlegen gegebenenfalls durch insbesondere auf die Außenkonturen des einzubettenden Bauteils (3) abgestimmte Lagen ummantelt und/oder durch wenigstens eine weitere Lage abgedeckt wird, ist vorgesehen, daß der zur Ausbildung der Klebeverbindung eingesetzte Kleber (2) mit einer konvexen Oberfläche (4) auf der zur Abstützung bzw. Aufnahme des elektronischen Bauteils (3) vorgesehenen Lage der Leiterplatte (1) aufgebracht wird, daß der festzulegende oder einzubettende Bauteil (3) auf dem Kleber (2) angeordnet wird und gegebenenfalls einer Druckbeanspruchung unterworfen wird, und daß der Kleber (2) nach dem Aufsetzen bzw. Anordnen des Bauteils (3) einer Härtungsbehandlung unterworfen wird, wodurch eine sichere Festlegung eines Bauteils (3) insbesondere unter Vermeidung von Hohlräumen oder Lufteinschlüssen unterhalb der Oberfläche (6) des festzulegenden Bauteils (3) erzielt werden kann.

Darüber hinaus werden ein Kleber wie eine Verwendung zur Verfügung gestellt.

Fig. 1

EP 2 416 633 A1

**Beschreibung**

Die vorliegende Erfindung bezieht sich auf ein Verfahren zur Festlegung eines elektronischen Bauteils an einer Leiterplatte und/oder zur Einbettung eines elektronischen Bauteils in eine Leiterplatte, wobei der festzulegende und/oder einzubettende elektronische Bauteil über eine Klebeverbindung an einer Lage bzw. Schicht einer insbesondere mehrlagigen Leiterplatte festgelegt wird und nach einem Festlegen gegebenenfalls durch insbesondere auf die Außenkonturen des einzubettenden Bauteils abgestimmte Lagen ummantelt und/oder durch wenigstens eine weitere Lage abgedeckt wird. Die vorliegende Erfindung bezieht sich darüber hinaus auf einen Kleber zur Verwendung in einem Verfahren zur Festlegung eines elektronischen Bauteils an einer Leiterplatte und/oder zur Einbettung eines elektronischen Bauteils in eine Leiterplatte sowie auf eine Verwendung eines derartigen Verfahrens oder eines derartigen Klebers.

Im Zusammenhang mit der Festlegung eines elektronischen Bauteils an bzw. auf einer Leiterplatte und/oder zur Einbettung eines elektronischen Bauteils in eine Leiterplatte tritt häufig das Problem auf, daß ein beispielsweise durch ein Druckverfahren auf eine Schicht bzw. Lage einer insbesondere mehrlagigen Leiterplatte aufgebrachter Kleber nach einem Anordnen bzw. Aufsetzen eines festzulegenden oder einzubettenden Bauteils unterhalb des festzulegenden oder einzubettenden Bauteils einen mit Luft gefüllten Hohlraum bildet, welcher selbst nach einer nachfolgenden Aushärtung des Klebers verbleibt. Ein derartig mit Luft bzw. Gas gefüllter Hohlraum unterhalb der beispielsweise im wesentlichen planen Oberfläche des Bauteils ist insbesondere durch die Form des Klebers nach einem Aufbringen auf der Schicht bzw. Lage im wesentlichen ähnlich einem Krater bzw. mit entsprechender größerer Höhe in Randbereichen der Aufbringungsfläche bedingt. Im Rahmen einer weiteren Bearbeitung einer mit einem derartigen Bauteil versehenen Leiterplatte kommen wenigstens teilweise erhöhte Temperaturen zur Anwendung, wobei bei derart hohen Temperaturen der unter dem Bauteil befindliche und mit Luft gefüllte Hohlraum zu Verspannungen im Bereich der Festlegung des Bauteils an der Leiterplatte oder sogar zu einer Zerstörung der Klebeverbindung und somit einem Abheben bzw. Lösen des Bauteils oder im schlimmsten Fall zu einer Zerstörung des Bauteils führen kann. Darüber hinaus muß beispielsweise für nachfolgende Kontaktierungsschritte sichergestellt werden, daß die zwischen dem Bauteil und der Schicht bzw. Lage der Leiterplatte befindliche Kleberschicht gleichmäßig und einheitlich unter der gesamten Fläche des Bauteils vorliegt, um beispielsweise bei einer Ausbildung von Löchern bzw. Durchbrechungen für eine Kontaktierung, welche üblicherweise nachfolgend mit einem leitenden Material für eine ordnungsgemäße Kontaktierung gefüllt wird, eine definierte Anordnung der Kontaktstellen zu ermöglichen.

Die vorliegende Erfindung zielt daher darauf ab, ein Verfahren der eingangs genannten Art sowie einen Kleber zur Verwendung in einem derartigen Verfahren dahingehend weiterzubilden, daß die Probleme des oben genannten Standes der Technik vermieden werden und insbesondere sichergestellt wird, daß unter Vermeidung eines mit Luft gefüllten Hohlraums unter dem festzulegenden bzw. einzubettenden Bauteil eine gleichmäßige Anordnung des Klebers zwischen der Schicht bzw. Lage der Leiterplatte und der Oberfläche des festzulegenden oder einzubettenden Bauteils vorliegt.

Zur Lösung dieser Aufgaben ist ein Verfahren der eingangs genannten Art im wesentlichen dadurch gekennzeichnet, daß der zur Ausbildung der Klebeverbindung eingesetzte Kleber mit einer konvexen Oberfläche auf der zur Abstützung bzw. Aufnahme des elektronischen Bauteils vorgesehenen Lage der Leiterplatte aufgebracht wird, daß der festzulegende oder einzubettende Bauteil auf dem Kleber angeordnet wird und gegebenenfalls einer Druckbeanspruchung unterworfen wird, und daß der Kleber nach dem Aufsetzen bzw. Anordnen des Bauteils einer Härtungsbehandlung unterworfen wird. Dadurch, daß erfindungsgemäß vorgeschlagen wird, den Kleber, welcher zur Ausbildung der Klebeverbindung herangezogen bzw. eingesetzt wird, mit einer konvexen Oberfläche auf die Schicht bzw. Lage der Leiterplatte aufzubringen und nachfolgend den festzulegenden oder einzubettenden Bauteil auf dem Kleber anzuordnen, wird sichergestellt, daß eine Bildung eines mit Luft gefüllten Hohlraums unterhalb des festzulegenden oder einzubettenden Bauteils vermieden wird, da durch die konvexe Wölbung bzw. Formgebung des Klebers bei einer Anordnung des Bauteils auf der aufgebrachten Klebefläche Hohlräume sicher vermieden werden können. Durch Vorsehen der konvexen Oberfläche des Klebers und somit einer im wesentlichen maximalen Dicke des zur Ausbildung der Klebeverbindung herangezogenen Klebers in einem im wesentlichen mittigen Bereich wird somit eine gleichmäßige und homogene Verteilung des Klebers zwischen der zur Abstützung herangezogenen Schicht bzw. Lage der Leiterplatte und der Oberfläche des festzulegenden Bauteils sichergestellt, da insbesondere bei einer im wesentlichen parallelen Annäherung der entsprechenden Oberfläche des festzulegenden oder einzubettenden Bauteils zu der auf der Schicht bzw. Lage der Leiterplatte angeordneten Klebeoberfläche ausgehend von den im wesentlichen mittigen Bereich, welcher die höchste Erhebung der Klebeoberfläche durch Ausbildung der konvexen Oberfläche aufweist, bei einer weiteren Annäherung des Bauteils an die Schicht bzw. Lage ein vollständiges Entweichen von Luft jeweils in bzw. zu den Randbereichen des festzulegenden Bauteils auftritt. Nach der Anordnung des Bauteils auf der Schicht bzw. Lage unter Vermittlung der konvexen Klebeoberfläche und somit unter Vermeidung von Hohlräumen unterhalb des festzulegenden oder einzubettenden Bauteils erfolgt eine Härtungsbehandlung, in welcher dauerhaft die gleichmäßige und einheitliche Anordnung des Klebers unter Vermeidung von Hohlräumen oder Lufteinschlüssen sicher beibehalten wird.

Um ein Austreten von Kleber über die Konturen des festzulegenden oder einzubettenden Bauteils hinaus bei Versehen der konvexen Oberfläche des Klebers und somit während des Anordnens des Klebers beim Verteilen desselben ausgehend von einem im wesentlichen mittigen Teilbereich, welcher eine größte Dicke des Klebers aufweist, in Richtung zu Rand- bzw. Kantenbereichen zu vermeiden, wird gemäß einer bevorzugten Ausführungsform vorgeschlagen, daß der Kleber in einer gegenüber den Außenkonturen des festzulegenden oder einzubettenden Bauteils verringerten Abmessung auf der Lage zur Abstützung bzw. Aufnahme des Bauteils aufgebracht wird. Durch Vorsehen einer verringerten Abmessung des auf der Schicht bzw. Lage der Leiterplatte angeordneten Klebers wird somit bedingt durch die Verteilung des mit einer konvexen Oberfläche aufgebrachten Klebers während des Annäherns des Bauteils an die Schicht bzw. Lage unter Vermittlung der Klebeverbindung eine gleichmäßige und einheitliche Klebefläche zwischen der Schicht bzw. Lage der Leiterplatte und dem Bauteil sichergestellt. Gleichzeitig wird ein insbesondere übermäßiges Austreten des Klebers über Randbereiche bzw. Außenkonturen des festzulegenden oder einzubettenden Bauteils vermieden.

Zur Erzielung der angestrebten gleichmäßigen Verteilung des Klebers unter Einhaltung der konvexen Oberfläche desselben vor Anordnung des festzulegenden oder einzubettenden Bauteils wird darüber hinaus vorgeschlagen, daß der Kleber in Bereichen entsprechend Randbereichen der Außenkontur des festzulegenden oder einzubettenden Bauteils mit einer geringeren Stärke bzw. Dicke und/oder in geringerer Menge aufgebracht wird, wie dies einer weiters bevorzugten Ausführungsform des erfindungsgemäßen Verfahrens entspricht.

Um insbesondere bei großflächigen Bauteilen übermäßige Ansammlungen von Kleber in Teilbereichen zu verhindern und eine gleichmäßige Verteilung des Klebers über die gesamte Oberfläche des festzulegenden oder einzubettenden Bauteils sicherzustellen, wird gemäß einer weiters bevorzugten Ausführungsform vorgeschlagen, daß der Kleber lediglich in Teilbereichen entsprechend der Außenkontur des festzulegenden oder einzubettenden Bauteils auf der Lage zur Abstützung des Bauteils aufgebracht wird, wobei der Kleber in sämtlichen, gegebenenfalls voneinander getrennten Teilbereichen mit einer konvexen Oberfläche aufgebracht wird. Derart kann insbesondere in Anpassung an die Abmessungen des Bauteils nach Anordnung des Bauteils auf der konvexen Klebeoberfläche eine gleichmäßige und einheitliche Verteilung des Klebers zwischen der Oberfläche des festzulegenden oder einzubettenden Bauteils und der entsprechenden Schicht bzw. Lage der Leiterplatte erhalten werden.

Zur weiteren Unterstützung der gleichmäßigen und einheitlichen Verteilung des Klebers und ergänzend zur Vermeidung eines Austritts des Klebers über Randbereiche oder die Außenkonturen des einzubettenden oder festzulegenden Bauteils hinaus wird darüber hinaus vorgeschlagen, daß der Kleber bei einem im wesentlichen rechteckigen bzw. rechtwinkeligen Bauteil mit einer polster- bzw. kissenartigen Erstreckung aufgebracht wird, wie dies einer weiters bevorzugten Ausführungsform des erfindungsgemäßen Verfahrens entspricht. Mit einer derartigen polster- bzw. kissenartigen Erstreckung unter Bereitstellung einer konvexen Oberfläche und in Anpassung an einen im wesentlichen rechteckigen bzw. rechtwinkeligen Bauteil kann nach einer Anordnung des Bauteils eine gleichmäßige und einheitliche Verteilung unter Vermeidung sämtlicher Lufteinschlüsse und von Hohlräumen zur Verfügung gestellt werden.

Zur zuverlässigen Erzielung der konvexen Oberfläche wird gemäß einer weiters bevorzugten Ausführungsform vorgeschlagen, daß die Oberflächenspannung des Klebers geringer als 40 mN/m, insbesondere zwischen 15 und 35 mN/m gewählt wird. Durch entsprechende Wahl bzw. Einstellung der Oberflächenspannung des Klebers wird bei einem Auftragen desselben auf der abstützenden Schicht bzw. Lage der Leiterplatte für eine Vermeidung von Lufteinschlüssen bei einer Festlegung des Bauteils die erfindungsgemäß vorgeschlagene konvexe Oberfläche bereitgestellt.

Zur Unterstützung einer Einnahme bzw. Bereitstellung einer konvexen Oberfläche des Klebers bei einem Aufbringen desselben wird gemäß einer weiters bevorzugten Ausführungsform vorgeschlagen, daß ein Kleber mit einer bei Raumtemperatur gegenüber seiner Elastizität höheren Viskosität gewählt wird.

In diesem Zusammenhang wird gemäß einer weiters bevorzugten Ausführungsform vorgeschlagen, daß der Kleber bei Raumtemperatur eine komplexe Viskosität unter 50 Pa.s, insbesondere zwischen etwa 20 und 45 Pa.s aufweist. Bei Einhaltung dieser erfindungsgemäß vorgeschlagenen Parameter für die Viskosität des Klebers bei Raumtemperatur kann die für eine ordnungsgemäße Festlegung unter Vermeidung von Hohlräumen angestrebte konvexe Oberfläche des Klebers zuverlässig erhalten werden. Die komplexe Viskosität ist die frequenzabhängige Viskositätsfunktion, welche während einer erzwungenen harmonischen Oszillation einer Scherbeanspruchung erhalten wird.

Wie oben bereits ausgeführt, sind eine Leiterplatte und deren Bauteile während weiterer Bearbeitungsschritte üblicherweise hohen Temperaturen und gegebenenfalls hohen Drücken ausgesetzt. Um selbst bei gegenüber der Anordnung des Bauteils unter Vermittlung der Klebeschicht insbesondere bei Raumtemperatur geänderten Umgebungsbedingungen ein sicheres Anhaften und die gleichmäßige und einheitliche Bereitstellung einer Klebeschicht unterhalb des Bauteils unter Vermeidung von Hohlräumen zur Verfügung zu stellen, wird gemäß einer weiters bevorzugten Ausführungsform vorgeschlagen, daß der Kleber eine temperaturbedingte Zunahme der komplexen Viskosität bei einer Erwärmung von Raumtemperatur auf etwa 50 °C und innerhalb eines Zeitraums von weniger als 15 min, insbesondere etwa 10 min, insbesondere auf das wenigstens 1,3-fache, insbesondere etwa 1,7- bis 3-fache der komplexen Viskosität bei Raumtemperatur aufweist. Derart wird auch während nachfolgender Be- bzw. Verarbeitungsschritte die sichere Anhaftung des Bauteils an der Leiterplatte ermöglicht.

Für eine besonders einfache und zuverlässige Aufbringung des Klebers mit der erfindungsgemäß vorgeschlagenen konvexen Oberfläche wird darüber hinaus vorgeschlagen, daß der Kleber in an sich bekannter Weise durch ein Druckverfahren, insbesondere Siebdruckverfahren aufgebracht wird, wie dies einer weiters bevorzugten Ausführungsform des erfindungsgemäßen Verfahrens entspricht.

Zur Lösung der oben angeführten Aufgaben ist darüber hinaus ein Kleber der eingangs genannten Art im wesentlichen dadurch gekennzeichnet, daß ein Kleber auf Epoxidharzbasis gewählt ist, welcher zur Einstellung der Oberflächenspannung und/oder Viskosität wenigstens ein Zusatzmittel, insbesondere einen Entschäumer und/oder einen Zusatzstoff zur Einstellung der Verlaufseigenschaften zugesetzt aufweist. Durch Bereitstellung eines Klebers auf Epoxidharzbasis werden die für ein zuverlässiges Anhaften erforderlichen Eigenschaften der Klebeverbindung bereitgestellt, wobei durch Zusatzmittel die zur Erzielung der konvexen Oberfläche erforderliche Oberflächenspannung und/oder Viskosität eines derartigen Klebers auf Epoxidharzbasis erzielbar ist (sind).

Zur Einstellung der erforderlichen Oberflächenspannung und/oder Viskosität wird gemäß einer bevorzugten Ausführungsform vorgeschlagen, daß ein Entschäumer, beispielsweise ein silikonfreier Entschäumer, in einer Menge von weniger als 3 Gew.-%, insbesondere etwa 0,1 bis 2,0 Gew.-% dem Kleber zugesetzt ist. Durch Zusatz eines Entschäumers in der angegebenen Menge können die gewünschten Eigenschaften im Hinblick auf eine Ausbildung einer konvexen Oberfläche insbesondere unter Beibehaltung der Klebeeigenschaften des Klebers erzielt werden.

Zur Einstellung von gewünschten Verlaufseigenschaften zur Erzielung der konvexen Oberfläche wird darüber hinaus vorgeschlagen, daß als Zusatzstoff zur Verbesserung der Verlaufseigenschaften ein Acrylat, beispielsweise Polybutylacrylat, ein Acrylat-Copolymer, beispielsweise Methacrylat-Copolymer, ein Epoxidharz mit freien Hydroxyl-, Isocyanat-und/oder Estergruppen oder dgl. zugesetzt ist, wie dies einer weiters bevorzugten Ausführungsform des erfindungsgemäßen Klebers entspricht. In diesem Zusammenhang wird gemäß einer weiters bevorzugten Ausführungsform vorgeschlagen, daß ein Zusatzstoff zur Verbesserung der Verlaufseigenschaften in einer Menge von maximal 7 Gew.-%, insbesondere 0,5 bis 5 Gew.-% zugesetzt ist.

Insbesondere zur Anpassung an unterschiedliche Einsatzzwecke und/oder zur Anpassung an unterschiedliche nachfolgende Be- bzw. Verarbeitungsschritte wird erfindungsgemäß bevorzugt vorgeschlagen, daß eine Mehrzahl von unterschiedlichen Zusatzstoffen zur Verbesserung der Verlaufseigenschaften zugesetzt ist.

Wie oben bereits erwähnt, ist bzw. wird die erfindungsgemäß vorzusehende konvexe Oberfläche des Klebers insbesondere durch die Oberflächenspannung desselben beeinflußt, wobei in diesem Zusammenhang vorgeschlagen wird, daß der Kleber eine Oberflächenspannung geringer als 40 mN/m, insbesondere zwischen 15 und 35 mN/m aufweist, wie dies einer bevorzugten Ausführungsform des Klebers entspricht.

Ebenfalls zur Unterstützung einer zuverlässigen Ausbildung einer konvexen Oberfläche wird bevorzugt vorgeschlagen, daß der Kleber bei Raumtemperatur eine gegenüber seiner Elastizität höhere Viskosität aufweist.

Zur Erzielung und Aufrechterhaltung der gleichmäßigen und einheitlichen Klebeschicht zwischen der Leiterplatte und der Oberfläche des einzubettenden oder festzulegenden Bauteils wird gemäß einer weiters bevorzugten Ausführungsform vorgeschlagen, daß der Kleber bei Raumtemperatur eine komplexe Viskosität unter 50 Pa.s, insbesondere zwischen etwa 20 und 45 Pa.s aufweist. Darüber hinaus wird in diesem Zusammenhang zur Beibehaltung der Eigenschaften des Klebers bei erhöhten Temperaturen vorgeschlagen, daß der Kleber eine temperaturbedingte Zunahme der komplexen Viskosität bei einer Erwärmung von Raumtemperatur auf etwa 50 °C und innerhalb eines Zeitraums von weniger als 15 min, insbesondere etwa 10 min, insbesondere auf das wenigstens 1,3-fache, insbesondere etwa 1,7- bis 3-fache der komplexen Viskosität bei Raumtemperatur aufweist.

Zur Lösung der eingangs genannten Aufgaben wird darüber hinaus erfindungsgemäß die Verwendung eines Verfahrens gemäß der vorliegenden Erfindung oder einer bevorzugten Ausführungsform als auch eines Klebers gemäß der Erfindung oder einer bevorzugten Ausführungsform zur Festlegung eines elektronischen Bauteils an bzw. auf einer Leiterplatte und/oder zur Einbettung eines elektronischen Bauteils in eine Leiterplatte vorgeschlagen.

Die Erfindung wird nachfolgend anhand von in der beiliegenden Zeichnung schematisch dargestellten Ausführungsbeispielen und von Beispielen von Zusammensetzungen des erfindungsgemäßen Klebers näher beschrieben. In der Zeichnung zeigen:

Fig. 1 eine schematische Teilansicht einer Leiterplatte, auf welcher unter Verwendung des erfindungsgemäßen Verfahrens sowie eines erfindungsgemäßen Klebers ein Bauteil festgelegt wird;

Fig. 2 eine idealisierte schematische Darstellung der Anordnung eines erfindungsgemäßen Klebers mit einer konvexen Oberfläche im Rahmen des erfindungsgemäßen Verfahrens;

Fig. 3 eine ebenfalls idealisierte Darstellung einer im wesentlichen kissenförmigen Anordnung eines erfindungsgemäßen Klebers im Rahmen des erfindungsgemäßen Verfahrens zur Festlegung eines insbesondere rechteckigen Bauteils; und

Fig. 4 eine Mehrzahl von schematischen Darstellungen bzw. Draufsichten ähnlich der Fig. 3 auf unterschiedliche Ausbildungen einer Aufbringung bzw. Anordnung eines erfindungsgemäßen Klebers im Rahmen des erfindungsgemäßen Verfahrens.

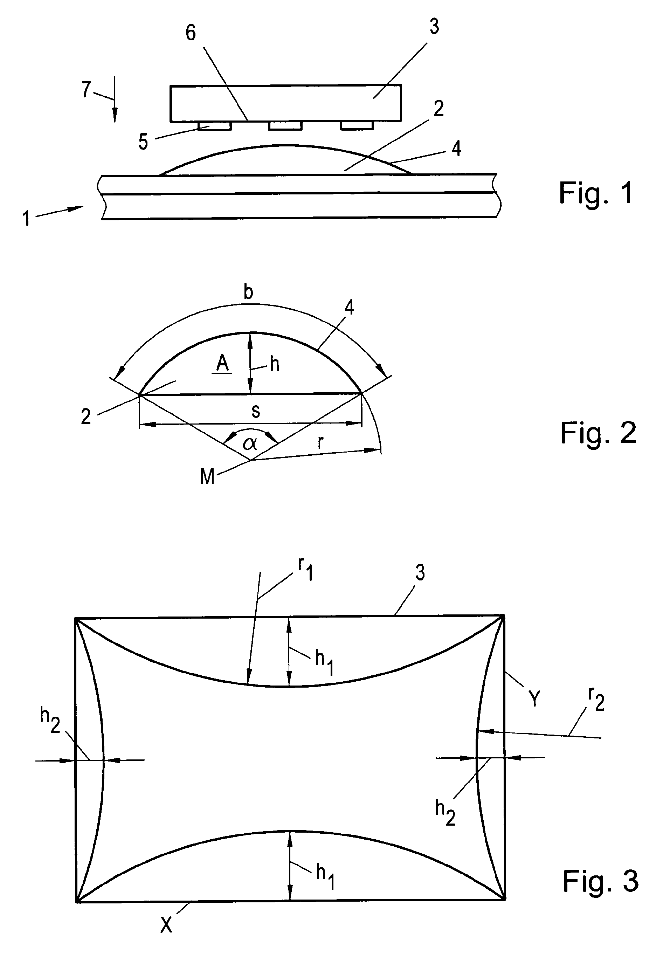

In Fig. 1 ist schematisch mit 1 eine beispielsweise mehrlagige Leiterplatte bezeichnet, auf welcher unter Vermittlung einer Kleberschicht 2 ein schematisch mit 3 angedeuteter elektronischer Bauteil festzulegen ist. Wie schematisch in Fig. 1 angedeutet, weist der Kleber 2, welcher zur Ausbildung der Klebeverbindung herangezogen wird, eine konvexe Oberfläche 4 auf, welche zum Bauteil 3 und insbesondere zu einer beispielsweise mit Kontakten 5 versehenen Oberfläche 6 gerichtet ist.

Für eine Festlegung wird der Bauteil 3 im Sinne des Pfeils 7 an die Leiterplatte 1, auf welcher der Kleber 2 beispielsweise durch ein Druckverfahren, insbesondere ein Siebdruckverfahren aufgebracht wurde, angenähert, wobei insbesondere durch die konvexe Oberfläche 4, welche in dem mittleren Bereich des Klebers 2 die größte Dicke bzw. Erstreckung aufweist, ein vollflächiges Anliegen der Oberfläche 4 des Klebers an der Oberfläche 6 des festzulegenden Bauteils 3 erzielt wird.

Nach einer Anordnung des Bauteils 3 auf bzw. Einbettung in dem Kleber 2 erfolgt beispielsweise ein Härten des Klebers 2.

Durch ein Vorsehen der konvexen Oberfläche 4 des Klebers 2 wird die Ausbildung von Hohlräumen bzw. Luftblasen unterhalb der Oberfläche 6 des festzulegenden Bauteils 3 vermieden, so daß insbesondere in nachfolgenden Be- bzw. Verarbeitungsschritten einer derartigen Leiterplatte ein Lösen bzw. Abheben des Bauteils 3 durch eine Ausdehnung des in einem Hohlraum eingeschlossenen Gases und gegebenenfalls eine Zerstörung des Bauteils 3 nicht befürchtet werden muß.

Anstelle des in Fig. 1 schematisch dargestellten Festlegens des Bauteils 3 an einer Oberfläche der Leiterplatte 1 kann auch unmittelbar eine Einbettung eines Bauteils 3 in einem entsprechenden Hohlraum bzw. einer Ausnehmung einer insbesondere mehrlagigen Leiterplatte vorgenommen werden. Alternativ zu einer Einbettung in einem Hohlraum kann nach einer Festlegung des Bauteils 3 an der Leiterplatte 1 unter Vermittlung der Klebeschicht 2 eine Ummantelung des Bauteils 3 zur Einbettung desselben vorgenommen werden.

In Fig. 2 ist eine idealisierte Darstellung der konvexen Oberfläche 4 einer wiederum mit 2 bezeichneten Kleberschicht angedeutet.

Die geometrischen Zusammenhänge in einem derartigen idealisierten Fall sind hiebei wie folgt:

$$b = r \cdot \pi \cdot \frac{\alpha}{180°},$$

$$h = r - \sqrt{r^2 - \left(\frac{s}{2}\right)^2}$$

$$A = \frac{r \cdot b}{2} - \frac{s \cdot (r - h)}{2}$$

Die Kreissehne s entspricht in einer idealisierten Anwendung einer Länge X bzw. Breite Y eines im wesentlichen rechteckigen Bauteils, dessen Konturen in Fig. 3 wiederum mit 3 bezeichnet ist.

Unter Berücksichtigung der angegebenen Formeln für die Ausbildung der konvexen Oberfläche 4 und einer Bereitstellung einer im wesentlichen kissenartigen Anordnung des Klebers 2 auf der nicht näher dargestellten Schicht bzw. Lage der Leiterplatte wird nach einem Anordnen des Bauteils 3, wie dies in Fig. 1 angedeutet ist, eine gleichmäßige und einheitliche Verteilung des Klebers 2 zwischen der abstützenden Schicht bzw. Lage der Leiterplatte und der zugewandten Oberfläche des Bauteils 3 erzielt. Unter Berücksichtigung der unterschiedlichen Abmessungen X und Y ergeben sich unterschiedliche Parameter $r_1$, $r_2$, $h_1$, $h_2$ in den obigen Formeln.

Aus Fig. 3 ist ersichtlich, daß durch die kissenartige Ausbildung unter Berücksichtigung der oben angeführten Bemaßungen und unter Ausbildung einer konvexen Oberfläche, wie dies in Fig. 1 und 2 angedeutet ist, über die gesamte Fläche des durch die Länge X bzw. Breite Y begrenzten Bauteils 3 eine sichere Anhaftung erzielt werden kann.

Darüber hinaus wird durch die kissenartige Ausbildung, bei welcher in Rand- bzw. Kantenbereichen im wesentlichen in mittigen Abschnitten entlang der Seiten, welche durch X und Y bezeichnet sind, ein Kleber 2 nicht bis zu den Randbereichen vorgesehen ist, und eine durch die konvexe Oberfläche bedingte Verteilung bei einer Anordnung des Bauteils 3 auf der Kleberoberfläche 2 sichergestellt, daß ein Austreten des Klebers 2 über die Außenkonturen des Bauteils 3 nicht auftritt. Derart wird vermieden, daß beispielsweise in weiteren Bearbeitungsschritten über die Außenkonturen des Bauteils 3 vorragende Reste des Klebers vor weiteren Bearbeitungsschritten entfernt werden müssen.

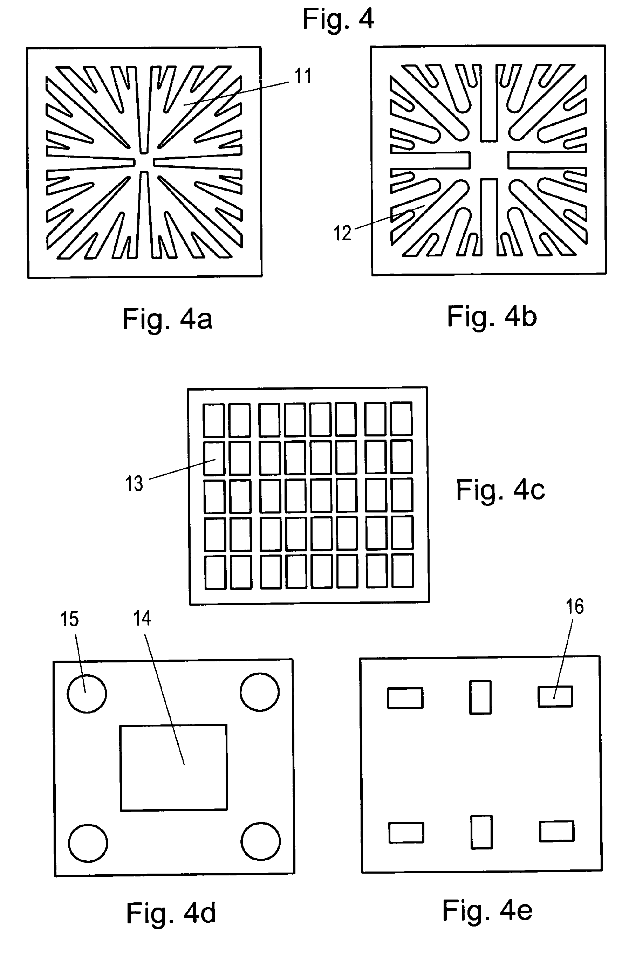

In Fig. 4 sind weitere abgewandelte Möglichkeiten einer Aufbringung eines Klebers jeweils schematisch für einen im wesentlichen quadratischen Bauteil angedeutet.

So finden bei den Ausführungen gemäß Fig. 4a und Fig. 4b im wesentlichen sternförmige und mit einer Vielzahl von Teilbereichen 11 und 12 versehene Kleberanordnungen Verwendung, wobei zwischen den einzelnen Teilbereichen 11 und 12 freie Flächen verbleiben. Die einzelnen Teilbereiche 11 und 12 weisen jeweils wiederum eine konvexe Oberfläche auf, so daß bei einem Aufbringen eines nicht näher dargestellten Bauteils eine gleichmäßige Verteilung des Klebers erzielt wird.

In Fig. 4c ist eine abgewandelte Ausführungsform dargestellt, wobei eine Vielzahl von im wesentlichen rechteckigen einzelnen Kleberflächen 13 nebeneinander entsprechend einer Matrix unter Berücksichtigung der Außenabmessungen des nicht dargestellten, festzulegenden Bauteils vorgesehen ist. Die einzelnen Teilbereiche 13 weisen jeweils wiederum eine konvexe Oberfläche auf, so daß bei einer Anordnung des Klebers durch die zwischen den Teilbereichen 13 vorgesehenen freien Flächen eine gleichmäßige Verteilung unter Vermeidung einer Ausbildung von Hohlräumen oder Lufteinschlüssen erzielbar ist.

Ähnliches gilt für die in Fig. 4d dargestellte Ausführungsform, wobei ein im wesentlichen mittiger Bereich 14, welcher wiederum eine konvexe Oberfläche des Klebers aufweist, und in Eckbereichen zusätzlich im wesentlichen kreisförmige Teilbereiche 15 vorgesehen sind.

Bei der in Fig. 4e dargestellten Ausführungsform sind im wesentlichen entlang von Seitenrändern bzw. Seitenkanten kleine Teilbereiche 16 vorgesehen, welche wiederum jeweils eine konvexe Wölbung aufweisen und eine gewünschte Festlegung mit gleichmäßiger Dicke jeweils in Randbereichen eines nicht näher dargestellten festzulegenden Bauteils ermöglichen.

Zur Erzielung der gewünschten konvexen Oberfläche des Klebers 2 bzw. von Teilbereichen 11, 12, 13, 14, 15, 16 hievon, wie sie insbesondere schematisch in Fig. 4 dargestellt sind, sind in der nachfolgenden Tabelle I physikalische Daten für unterschiedliche Ausführungsbeispiele von Klebern angegeben, wobei ergänzend ein Vergleichsbeispiel angeführt ist, welches jedoch die Bildung einer konvexen Oberfläche nicht ermöglicht.

Tabelle I

|  | Oberflächen-Spannung [mN/m] | komplexe Viskosität 20 °C [Pa.s] | komplexe Viskosität 50 °C, 10 min [Pa.s] |
|---|---|---|---|
| Bsp. 1 | 30,9 | 22 | 45 |
| Bsp. 2 | 31,6 | 33 | 43 |
| Bsp. 3 | 31,0 | 43 | 84 |
| Bsp. 4 | 32,3 | 23 | 67 |
| Vergl. Bsp. | 45,4 | 57 | 24 |

Aus der obigen Tabelle I ist ersichtlich, daß die Kleber gemäß Beispiel 1 bis 4, welche eine konvexe Oberfläche zur Verfügung stellen, jeweils eine Oberflächenspannung im Bereich von etwa 30 mN/m aufweisen, während die Oberflächenspannung entsprechend dem Vergleichsbeispiel etwa 45 mN/m beträgt.

Weiters ist ersichtlich, daß die komplexe Viskosität bei 20 °C für die Beispiele 1 bis 4 jeweils unter 50 Pa.s und insbesondere zwischen 20 und 45 Pa.s liegt, während der entsprechende Wert für das Vergleichsbeispiel über einer Grenze von 50 Pa.s liegt.

Darüber hinaus ist ersichtlich, daß die komplexe Viskosität bei einer Erwärmung auf 50 °C und innerhalb eines Zeitraums von 10 Minuten für die eine konvexe Oberfläche bildenden Beispiele 1 bis 4 ansteigt und insbesondere wenigstens das 1,3-fache, vorzugsweise das 1,7- bis 3-fache der komplexen Viskosität bei Raumtemperatur (20 °C) beträgt, während für das Vergleichsbeispiel die komplexe Viskosität auf weniger als die Hälfte derselben bei Raumtemperatur abnimmt.

Die komplexe Viskosität für die in Tabelle I genannten Beispiele und das Vergleichsbeispiel wurde für beide Temperaturen bei jeweils gleicher, standardisierter Amplitude der Oszillation und gleicher Winkelfrequenz von beispielsweise 6 (1/s) ermittelt.

In der nachfolgenden Tabelle II werden darüber hinaus Zusammensetzungen für eine Mehrzahl von Kleberformulierungen angeführt, welche ebenfalls wiederum eine konvexe Oberfläche des Klebers nach einem Aufbringen auf eine Schicht bzw. Lage einer Leiterplatte bereitstellen, während für Vergleichsbeispiele die Ausbildung einer konvexen Oberfläche nicht erzielt werden konnte.

Die Kleberformulierungen basieren jeweils auf Einkomponenten-Epoxidharzkleber mit einer Viskosität von etwa 20 Pa.s, welche durch Zugabe der angegebenen Zusatzstoffe entsprechend verändert wird.

Als Entschäumer wird in der nachfolgenden Tabelle ein silikonfreier Entschäumer, beispielsweise BYK-054 eingesetzt.

Zur Verbesserung der Verlaufseigenschaften wird beispielsweise ein Poly-Acrylat, beispielsweise BYK-S706 oder BYK-359 eingesetzt.

Die nachfolgenden Angaben beziehen sich jeweils auf Gew.-%.

TABELLE II

|  | Lösungsmittel % | Verlaufsmittel % | Entschäumer % |
|---|---|---|---|
| Bsp. 1 | - | 2 | 0,5 |
| Bsp. 2 | - | 2 | 1 |
| Bsp. 3 | - | 3 | 1 |
| Bsp. 4 | - | 4 | 1 |
| Bsp. 5 | 0,3 | 4 | 1 |
| Vergl. Bsp. 1 | 0,5 | - | 0,7 |
| Vergl. Bsp. 2 | 0,5 | - | 0,7 |

Aus der obigen Tabelle II ist ersichtlich, daß insbesondere durch Zusatz eines Verlaufsmittels und bei geringen Mengen eines Entschäumers eine konvexe Oberfläche gebildet wird.

Hiebei eignen sich die unter Beispiel 1 und 2 angegebenen Zusammensetzungen mit einer vergleichsweise geringen Menge an Verlaufsmittel und Entschäumer insbesondere für kleine Kleberflächen von beispielsweise kleiner als 2 x 2 mm.

Durch eine Erhöhung des Anteils an Verlaufsmittel wird insbesondere eine konvexe Oberfläche bei größeren Kleberflächen erzielbar. Hiebei hat sich eine Zusammensetzung gemäß Beispiel 3 bei Kleberflächen bis etwa 6 x 6 mm als geeignet erwiesen, während gemäß Beispiel 4 und 5 konvexe Oberflächen bis zu einer Abmessung von etwa 10 x 10 mm erzielbar sind.

Darüber hinaus zeigen die Zusammensetzungen gemäß Beispiel 4 und 5 sehr gute Verlaufseigenschaften. Weiters ist durch zusätzliches Vorsehen eines Lösungsmittels ein Entschäumern in Gebinden bei Beispiel 5 erzielbar.

Im Gegensatz dazu konnte bei den Vergleichsbeispielen zwar eine entschäumende Wirkung erhalten werden, wobei jedoch insbesondere durch das Fehlen eines Verlaufsmittels und somit die Möglichkeit einer Einstellung der Oberflächenspannung, wie sie in Tabelle I angegeben ist, auf einen einzustellenden Wert von weniger als 40 mN/m und insbesondere weniger als 35 mN/m die Ausbildung einer konvexen Oberfläche des Klebers nach einem Druckverfahren, insbesondere einem Siebdruckverfahren nicht erzielt werden konnte.

**Patentansprüche**

1. Verfahren zur Festlegung eines elektronischen Bauteils (3) an einer Leiterplatte (1) und/oder zur Einbettung eines elektronischen Bauteils (3) in eine Leiterplatte (1), wobei der festzulegende und/oder einzubettende elektronische Bauteil (3) über eine Klebeverbindung (2) an einer Lage bzw. Schicht einer insbesondere mehrlagigen Leiterplatte (1) festgelegt wird und nach einem Festlegen gegebenenfalls durch insbesondere auf die Außenkonturen des einzubettenden Bauteils (3) abgestimmte Lagen ummantelt und/oder durch wenigstens eine weitere Lage abgedeckt wird, **dadurch gekennzeichnet, daß** der zur Ausbildung der Klebeverbindung eingesetzte Kleber (2, 11-16) mit einer konvexen Oberfläche (4) auf der zur Abstützung bzw. Aufnahme des elektronischen Bauteils (3) vorgesehenen Lage der Leiterplatte (1) aufgebracht wird, daß der festzulegende oder einzubettende Bauteil (3) auf dem Kleber (2, 11-16) angeordnet wird und gegebenenfalls einer Druckbeanspruchung unterworfen wird, und daß der Kleber (2, 11-16) nach dem Aufsetzen bzw. Anordnen des Bauteils (3) einer Härtungsbehandlung unterworfen wird.

2. Verfahren nach Anspruch 1, **dadurch gekennzeichnet, daß** der Kleber (2, 11-16) in einer gegenüber den Außenkonturen des festzulegenden oder einzubettenden Bauteils (3) verringerten Abmessung auf der Lage zur Abstützung bzw. Aufnahme des Bauteils (3) aufgebracht wird.

3. Verfahren nach Anspruch 1 oder 2, **dadurch gekennzeichnet, daß** der Kleber (2, 11-16) in Bereichen entsprechend Randbereichen der Außenkontur des festzulegenden oder einzubettenden Bauteils (3) mit einer geringeren Stärke bzw. Dicke und/oder in geringerer Menge aufgebracht wird.

4. Verfahren nach Anspruch 1, 2 oder 3, **dadurch gekennzeichnet, daß** der Kleber (2, 11-16) lediglich in Teilbereichen entsprechend der Außenkontur des festzulegenden oder einzubettenden Bauteils (3) auf der Lage zur Abstützung des Bauteils (3) aufgebracht wird, wobei der Kleber in sämtlichen, gegebenenfalls voneinander getrennten Teilbereichen mit einer konvexen Oberfläche aufgebracht wird.

5. Verfahren nach einem der Ansprüche 1 bis 4, **dadurch gekennzeichnet, daß** der Kleber (2) bei einem im wesentlichen rechteckigen bzw. rechtwinkeligen Bauteil (3) mit einer polster- bzw. kissenartigen Erstreckung aufgebracht wird (Fig. 3).

6. Verfahren nach einem der Ansprüche 1 bis 5, **dadurch gekennzeichnet, daß** die Oberflächenspannung des Klebers (2, 11-16) geringer als 40 mN/m, insbesondere zwischen 15 und 35 mN/m gewählt wird.

7. Verfahren nach einem der Ansprüche 1 bis 6, **dadurch gekennzeichnet, daß** ein Kleber (2, 11-16) mit einer bei Raumtemperatur gegenüber seiner Elastizität höheren Viskosität gewählt wird.

8. Verfahren nach Anspruch 7, **dadurch gekennzeichnet, daß** der Kleber (2, 11-16) bei Raumtemperatur eine komplexe Viskosität unter 50 Pa.s, insbesondere zwischen etwa 20 und 45 Pa.s aufweist.

9. Verfahren nach Anspruch 7 oder 8, **dadurch gekennzeichnet, daß** der Kleber (2, 11-16) eine temperaturbedingte Zunahme der komplexen Viskosität bei einer Erwärmung von Raumtemperatur auf etwa 50 °C und innerhalb eines Zeitraums von weniger als 15 min, insbesondere etwa 10 min, insbesondere auf das wenigstens 1,3-fache, insbesondere etwa 1,7-bis 3-fache der komplexen Viskosität bei Raumtemperatur aufweist.

10. Verfahren nach einem der Ansprüche 1 bis 9, **dadurch gekennzeichnet, daß** der Kleber (2, 11-16) in an sich bekannter Weise durch ein Druckverfahren, insbesondere Siebdruckverfahren aufgebracht wird.

11. Kleber zur Verwendung in einem Verfahren zur Festlegung eines elektronischen Bauteils (3) an einer Leiterplatte (1) und/oder zur Einbettung eines elektronischen Bauteils (3) in eine Leiterplatte (1) gemäß einem der Ansprüche 1 bis 10, **dadurch gekennzeichnet, daß** ein Kleber (2, 11-16) auf Epoxidharzbasis gewählt ist, welcher zur Einstellung der Oberflächenspannung und/oder Viskosität wenigstens ein Zusatzmittel, insbesondere einen Entschäumer und/oder einen Zusatzstoff zur Einstellung der Verlaufseigenschaften zugesetzt aufweist.

12. Kleber nach Anspruch 11, **dadurch gekennzeichnet, daß** ein Entschäumer, beispielsweise ein silikonfreier Entschäumer, in einer Menge von weniger als 3 Gew.-%, insbesondere etwa 0,1 bis 2,0 Gew.-% dem Kleber zugesetzt ist.

13. Kleber nach Anspruch 11 oder 12, **dadurch gekennzeichnet, daß** als Zusatzstoff zur Verbesserung der Verlaufseigenschaften ein Acrylat, beispielsweise Polybutylacrylat, ein Acrylat-Copolymer, beispielsweise Methacrylat-Copolymer, ein Epoxiharz mit freien Hydroxyl-, Isocyanat-und/oder Estergruppen oder dgl. zugesetzt ist.

14. Kleber nach Anspruch 13, **dadurch gekennzeichnet, daß** ein Zusatzstoff zur Verbesserung der Verlaufseigenschaften in einer Menge von maximal 7 Gew.-%, insbesondere 0,5 bis 5 Gew.-% zugesetzt ist.

15. Kleber nach Anspruch 13 oder 14, **dadurch gekennzeichnet, daß** eine Mehrzahl von unterschiedlichen Zusatzstoffen zur Verbesserung der Verlaufseigenschaften zugesetzt ist.

16. Kleber nach einem der Ansprüche 11 bis 15, **dadurch gekennzeichnet, daß** der Kleber (2, 11-16) eine Oberflächenspannung geringer als 40 mN/m, insbesondere zwischen 15 und 35 mN/m aufweist.

17. Kleber nach einem der Ansprüche 11 bis 16, **dadurch gekennzeichnet, daß** der Kleber (2, 11-16) bei Raumtemperatur eine gegenüber seiner Elastizität höhere Viskosität aufweist.

18. Kleber nach einem der Ansprüche 11 bis 17, **dadurch gekennzeichnet, daß** der Kleber (2, 11-16) bei Raumtemperatur eine komplexe Viskosität unter 50 Pa.s, insbesondere zwischen etwa 20 und 45 Pa.s aufweist.

**19.** Kleber nach einem der Ansprüche 11 bis 18, **dadurch gekennzeichnet, daß** der Kleber (2, 11-16) eine temperaturbedingte Zunahme der komplexen Viskosität bei einer Erwärmung von Raumtemperatur auf etwa 50 °C und innerhalb eines Zeitraums von weniger als 15 min, insbesondere etwa 10 min, insbesondere auf das wenigstens 1,3-fache, insbesondere etwa 1,7- bis 3-fache der komplexen Viskosität bei Raumtemperatur aufweist.

**20.** Verwendung eines Verfahrens gemäß einem der Ansprüche 1 bis 10 sowie eines Klebers gemäß einem der Ansprüche 11 bis 19 zur Festlegung eines elektronischen Bauteils an einer Leiterplatte und/oder zur Einbettung eines elektronischen Bauteils in eine Leiterplatte.

Fig. 1

Fig. 2

Fig. 3

# Fig. 4

Fig. 4a

Fig. 4b

Fig. 4c

Fig. 4d

Fig. 4e

Europäisches Patentamt
European Patent Office
Office européen des brevets

## EUROPÄISCHER RECHERCHENBERICHT

Nummer der Anmeldung

EP 10 45 0127

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | US 2003/139004 A1 (YOSHIDA KOJI [JP]) 24. Juli 2003 (2003-07-24) * Abbildungen 2,3; Beispiel 1 * ----- | 1-4,6-9, 20 | INV. H05K3/30 H01L21/56 H05K13/04 C09J163/00 |
| X | US 6 234 379 B1 (DONGES WILLIAM E [US]) 22. Mai 2001 (2001-05-22) * das ganze Dokument * ----- | 1-3,5-9, 20 | |
| X | US 2003/059978 A1 (SUZUKI OSAMU [JP] ET AL) 27. März 2003 (2003-03-27) * Absatz [0028] - Absatz [0035]; Abbildung 1 * ----- | 1-20 | |
| X | EP 1 956 873 A2 (FUJITSU LTD [JP]) 13. August 2008 (2008-08-13) * Absatz [0044] - Absatz [0048]; Abbildung 3 * ----- | 1,20 | |
| X | DATABASE WPI Week 200875 Thomson Scientific, London, GB; AN 2008-M71354 XP000002658984, & JP 2008 239822 A (MATSUSHITA ELECTRIC WORKS LTD) 9. Oktober 2008 (2008-10-09) * Zusammenfassung * ----- | 11-20 | RECHERCHIERTE SACHGEBIETE (IPC) H05K H01L C09J |
| X | WO 03/075338 A1 (NAT STARCH CHEM INVEST [US]) 12. September 2003 (2003-09-12) * Tabelle 1 * * Seite 11, Zeile 20 * * Seite 11, Zeile 1 - Zeile 19 * ----- | 11-20 | |
| X | WO 99/67324 A1 (LOCTITE CORP [US]; TORRES FILHO AFRANIO [US]; CRANE LAWRENCE N [US]) 29. Dezember 1999 (1999-12-29) * Ansprüche 1,6,7; Tabellen 1,2 * * Seite 14, Zeile 35 * ----- | 11-20 | |

Der vorliegende Recherchenbericht wurde für alle Patentansprüche erstellt

| Recherchenort | Abschlußdatum der Recherche | Prüfer |
|---|---|---|
| Den Haag | 29. September 2011 | O'Sullivan, Timothy |

Europäisches
Patentamt

European
Patent Office

Office européen
des brevets

**Nummer der Anmeldung**

EP 10 45 0127

## GEBÜHRENPFLICHTIGE PATENTANSPRÜCHE

Die vorliegende europäische Patentanmeldung enthielt bei ihrer Einreichung Patentansprüche, für die eine Zahlung fällig war.

☐ Nur ein Teil der Anspruchsgebühren wurde innerhalb der vorgeschriebenen Frist entrichtet. Der vorliegende europäische Recherchenbericht wurde für jene Patentansprüche erstellt, für die keine Zahlung fällig war, sowie für die Patentansprüche, für die Anspruchsgebühren entrichtet wurden, nämlich Patentansprüche:

☐ Keine der Anspruchsgebühren wurde innerhalb der vorgeschriebenen Frist entrichtet. Der vorliegende europäische Recherchenbericht wurde für die Patentansprüche erstellt, für die keine Zahlung fällig war.

## MANGELNDE EINHEITLICHKEIT DER ERFINDUNG

Nach Auffassung der Recherchenabteilung entspricht die vorliegende europäische Patentanmeldung nicht den Anforderungen an die Einheitlichkeit der Erfindung und enthält mehrere Erfindungen oder Gruppen von Erfindungen, nämlich:

Siehe Ergänzungsblatt B

☒ Alle weiteren Recherchengebühren wurden innerhalb der gesetzten Frist entrichtet. Der vorliegende europäische Recherchenbericht wurde für alle Patentansprüche erstellt.

☐ Da für alle recherchierbaren Ansprüche die Recherche ohne einen Arbeitsaufwand durchgeführt werden konnte, der eine zusätzliche Recherchengebühr gerechtfertigt hätte, hat die Recherchenabteilung nicht zur Zahlung einer solchen Gebühr aufgefordert.

☐ Nur ein Teil der weiteren Recherchengebühren wurde innerhalb der gesetzten Frist entrichtet. Der vorliegende europäische Recherchenbericht wurde für die Teile der Anmeldung erstellt, die sich auf Erfindungen beziehen, für die Recherchengebühren entrichtet worden sind, nämlich Patentansprüche:

☐ Keine der weiteren Recherchengebühren wurde innerhalb der gesetzten Frist entrichtet. Der vorliegende europäische Recherchenbericht wurde für die Teile der Anmeldung erstellt, die sich auf die zuerst in den Patentansprüchen erwähnte Erfindung beziehen, nämlich Patentansprüche:

☐ Der vorliegende ergänzende europäische Recherchenbericht wurde für die Teile der Anmeldung erstellt, die sich auf die zuerst in den Patentansprüchen erwähnte Erfindung beziehen (Regel 164 (1) EPÜ).

Europäisches
Patentamt

European
Patent Office

Office européen
des brevets

**MANGELNDE EINHEITLICHKEIT
DER ERFINDUNG
ERGÄNZUNGSBLATT B**

**Nummer der Anmeldung**

EP 10 45 0127

Nach Auffassung der Recherchenabteilung entspricht die vorliegende europäische Patentanmeldung nicht den Anforderungen an die Einheitlichkeit der Erfindung und enthält mehrere Erfindungen oder Gruppen von Erfindungen, nämlich:

1. Ansprüche: 1-10(vollständig); 20(teilweise)

   Verfahren zur Festlegung eines elektronischen Bauteils an einer Leiterplatte, dadurch gekennzeichnet, dass der zur Ausbildung der Klebeverbindung eingesetzte Kleber mit einer konvexen Oberfläche aufgebracht wird
   ---

2. Ansprüche: 11-19(vollständig); 20(teilweise)

   Kleber (geeignet) zur Verwendung in einem Verfahren zur Festlegung eines elektronischen Bauteils an einer Leiterplatte
   ---

**ANHANG ZUM EUROPÄISCHEN RECHERCHENBERICHT
ÜBER DIE EUROPÄISCHE PATENTANMELDUNG NR.**

EP 10 45 0127

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

29-09-2011

| Im Recherchenbericht angeführtes Patentdokument | Datum der Veröffentlichung | Mitglied(er) der Patentfamilie | | Datum der Veröffentlichung |
|---|---|---|---|---|
| US 2003139004 A1 | 24-07-2003 | CN | 1462474 A | 17-12-2003 |
| | | EP | 1369911 A1 | 10-12-2003 |
| | | WO | 02073686 A1 | 19-09-2002 |
| | | JP | 2002270642 A | 20-09-2002 |
| US 6234379 B1 | 22-05-2001 | KEINE | | |
| US 2003059978 A1 | 27-03-2003 | DE | 10196082 B4 | 14-06-2007 |
| | | DE | 10196082 T1 | 13-03-2003 |
| | | WO | 0180302 A1 | 25-10-2001 |
| | | JP | 2002313841 A | 25-10-2002 |
| EP 1956873 A2 | 13-08-2008 | CN | 101227798 A | 23-07-2008 |
| | | JP | 2008177351 A | 31-07-2008 |
| | | KR | 20080068531 A | 23-07-2008 |
| | | US | 2011025507 A1 | 03-02-2011 |
| | | US | 2008173997 A1 | 24-07-2008 |
| JP 2008239822 A | 09-10-2008 | KEINE | | |
| WO 03075338 A1 | 12-09-2003 | AU | 2003212987 A1 | 16-09-2003 |
| | | CN | 1650412 A | 03-08-2005 |
| | | EP | 1481419 A1 | 01-12-2004 |
| | | JP | 4276085 B2 | 10-06-2009 |
| | | JP | 2005519168 A | 30-06-2005 |
| | | US | 2003171456 A1 | 11-09-2003 |
| WO 9967324 A1 | 29-12-1999 | AU | 4688699 A | 10-01-2000 |

EPO FORM P0461

Für nähere Einzelheiten zu diesem Anhang : siehe Amtsblatt des Europäischen Patentamts, Nr.12/82